Europäisches Patentamt

European Patent Office

Office européen des brevets

(19)

(11) Veröffentlichungsnummer: **0 444 258 A2**

## (12) EUROPÄISCHE PATENTANMELDUNG

(21) Anmeldenummer: 90123354.4

(22) Anmeldetag: 05.12.90

(51) Int. Cl.5: **H01L 21/306**

(30) Priorität: 01.03.90 DE 4006461

(43) Veröffentlichungstag der Anmeldung:
04.09.91 Patentblatt 91/36

(84) Benannte Vertragsstaaten:
**DE FR GB IT**

(71) Anmelder: **Siemens Aktiengesellschaft**
**Wittelsbacherplatz 2**
**W-8000 München 2(DE)**

(72) Erfinder: **Engelhardt, Manfred, Dr.**
**Edelweissstrasse 1a**
**W-8152 Feldkirchen-Westerham(DE)**

(54) **Verfahren zur Ermittlung eines Zusammenhangs zwischen einer Substratschädigung und Prozessparametern für einen Trockenätzprozess.**

(57) Zur Ermittlung eines Zusammenhangs zwischen einer Substratschädigung und Prozeßparametern für einen Trockenätzprozeß wird mindestens eine unbehandelte Halbleiterscheibe dem Trockenätzprozeß unterzogen, wobei die Prozeßparameter für stabile Prozeßbedingungen eingestellt werden. In der Oberfläche der Halbleiterscheibe werden berührungslos Temperatur- und Plasmawellen angeregt. Die Stärke $\Delta$ TW der Wechselwirkung der Temperatur- und Plasmawellen mit der Oberfläche der Halbleiterscheibe, die ein Maß für Substratschädigungen darstellt, wird berührungslos gemessen. Das Verfahren ist insbesondere zur Ermittlung von hinsichtlich minimaler Substratschädigung optimalen Prozeßparametern für einen Silizium-Trockenätzprozeß anwendbar.

FIG 5

EP 0 444 258 A2

Die Erfindung betrifft ein Verfahren zur Ermittlung eines Zusammenhangs zwischen einer Substratschädigung und Prozeßparametern für einen Trockenätzprozeß.

Bei der Herstellung eines elektronischen Bauelementes in einem Halbleitersubstrat ist der Ablauf einer Vielzahl von Prozeßschritten erforderlich. Oft hängen die elektrischen Eigenschaften des hergestellten Bauelementes entscheidend von einzelnen Prozeßschritten ab. Bei der Erzeugung von Grabenzellen für hochintegrierte DRAMs ist die Grabenätzung mit Hilfe von Trockenätzprozessen ein solcher kritischer Prozeß, da hohe Anforderungen an das Grabenprofil gestellt werden.

Die Beurteilung der Ausbeute erfolgt im allgemeinen mit elektrischen Messungen nach einem Chargendurchlauf. Die Beurteilung der Ausbeute kann ebenfalls über die Messung der Qualität eines Gateoxids erfolgen, das in den mit dem Trockenätzprozeß erzeugten Strukturen erzeugt wurde.

Bei Trockenätzprozessen mit Plasmen in einem höheren Druckbereich (z. B. einige 100 hPa) ist eine Beurteilung des Ergebnisses des Trockenätzprozesse während des Herstellverfahrens mit dem sogenannten Thermal-Wave-Verfahren möglich. In diesem Verfahren werden berührungslos Temperatur- und Plasmawellen in einem Bereich eines Halbleitersubstrats aus z. B. Silizium angeregt. Die Wechselwirkung zwischen den Temperatur- und Plasmawellen und dem Halbleitersubstrat werden berührungslos gemessen. Die Anwendung dieses Verfahrens zur Beurteilung der Ausbeute während eines Chargendurchlaufes ist z. B. aus M. Engelhardt, Proc. 9th Int. Symp. on Plasma Chemistry (ISPC-9) Sept. 1989, p. 978 (1989) bekannt.

Das Prozessieren von Halbleitersubstraten ist mit Plasmen in diesem Druckbereich jedoch mit stabilen Plasma- und damit Prozeßbedingungen nur möglich, wenn die Halbleiterscheiben strukturiert sind, so daß das Halbleitermaterial, z. B. Silizium, in kleinen Gebieten freiliegt. Im Beispiel einer Grabenzelle ist dieses Verfahren nur möglich, wenn an dem Halbleitersubstrat die Verfahrensschritte Phototechnik, Trenchebene, Maskenschichten sowie CVD-Siliziumdioxid bereits erfolgt sind.

Auch bei Verwendung des Thermal-Wave-Verfahrens kann erst nach Ablauf einer Vielzahl von Prozeßschritten festgestellt werden, ob die Prozeßparameter, bei denen der Ätzprozeß abläuft, hinsichtlich Substratschädigung, und damit hinsichtlich Ausbeute, optimal sind.

Der Erfindung liegt daher die Aufgabe zugrunde, ein Verfahren anzugeben, mit dem eine Voraussage der Ausbeute von Trockenätzprozessen in einem frühen Stadium des Herstellverfahrens möglich ist.

Diese Aufgabe wird erfindungsgemäß gelöst mit einem Verfahren zur Ermittlung eines Zusammenhangs zwischen einer Substratschädigung und Prozeßparametern für einen Trockenätzprozeß mit folgenden Schritten:

a) mindestens eine unbehandelte Halbleiterscheibe wird dem Trockenätzprozeß unterzogen, wobei die Prozeßparameter für stabile Prozeßbedingungen eingestellt werden,

b) in der Oberfläche der Halbleiterscheibe werden berührungslos Temperatur- und Plasmawellen angeregt,

c) die Stärke der Wechselwirkung der Temperatur- und Plasmawellen mit der Oberfläche der Halbleiterscheibe wird berührungslos gemessen.

Weitere Ausgestaltungen der Erfindung gehen aus den Unteransprüchen hervor.

Die folgenden Überlegungen haben zu der Erfindung geführt. In Niederdruckplasmen im Druckbereich von einigen hPa und darunter ist das Prozessieren von einkristallinen Halbleitersubstraten aus z. B. Silizium mit stabilen Plasmabedingungen auch dann möglich, wenn die Halbleitersubstrate unbehandelt, d. h. blank sind. Die Ätzraten für z. B. Silizium hängen dabei im wesentlichen nicht von der Größe der dem Plasma ausgesetzten (d. h. nicht mit einer Maskenschicht abgedeckten) Siliziumfläche ab. Ein Microloading-Effekt wird nicht beobachtet, so daß kleine Strukturen wie z. B. Trenchlöcher mit einem Durchmesser von ungefähr 1 $\mu m^2$ mit denselben Raten geätzt werden wie Gebiete, in denen Silizium großflächig freiliegt.

Zur Ermittlung optimaler Prozeßparameter, bei denen es zu einer minimalen Substratschädigung bei einem Trockenätzprozeß kommt, werden blanke Halbleiterscheiben z. B. aus Silizium in einem solchen Niederdruckplasma prozessiert. Durch Anregung von Temperatur- und Plasmawellen in der Oberfläche der Halbleiterscheibe z. B. mit dem Thermal-Wave-Verfahren wird die Substratschädigung gemessen. Duch Variation der Prozeßparameter und anschließender Messung der Substratschädigung werden optimale Prozeßparameter hinsichtlich minimaler Substratschädigung ermittelt. Diese Parameter können anschließend in einem Herstellprozeß für ein Bauelement eingesetzt werden. Es ist dann von vornherein mit einer optimalen Ausbeute des Prozesse zu rechnen.

Im folgenden wird die Erfindung anhand eines Ausführungsbeispiels näher erläutert.

In dem Ausführungsbeispiel wird ein Reaktor einer MCR (magnetically confined reactor)-Anlage z. B. vom Typ MCR 2000 der Firma TEGAL, der in P. Norris, O. Krogh, Proc. 9th Int. Symp. on Plasma Chemistry (ISPC-9) Sept. 1989, p. 645 (1989) beschrieben ist, verwendet. In einem solchen Reaktor in einer solchen Anlage ist eine Halterung für eine Halbleiterscheibe vorgesehen, an die eine Radiofrequenz von 100 kHz mit einstellbarer Leistung angelegt wird. Des weiteren ist in der Anlage eine Ringelektrode vorgesehen, an die eine Radiofrequenz von 13, 56 MHz angelegt wird. Die Leistungen der 13,56 MHz RF und der 100 kHz RF sind unabhängig voneinander einstellbar. Dadurch ist die Dichte der reaktiven Teilchen unabhängig von der kinetischen Energie der reaktiven Teilchen einstellbar.

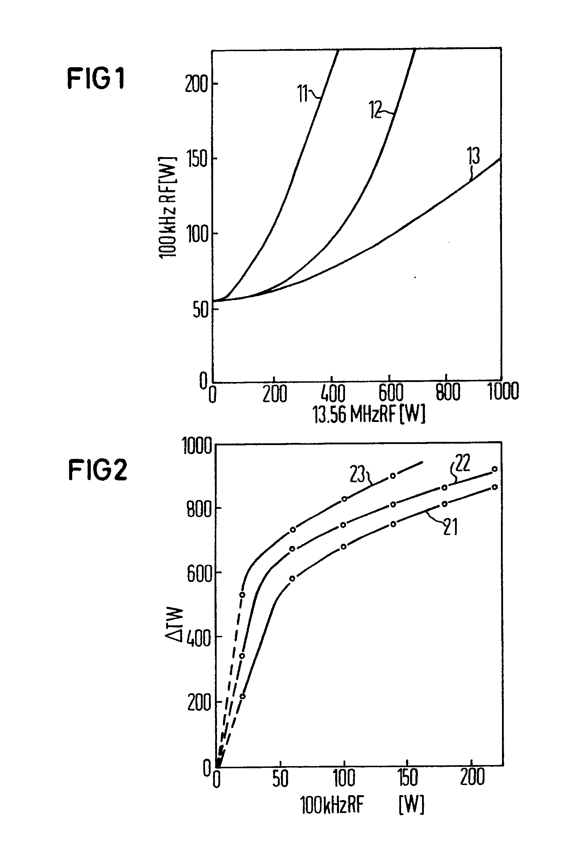

In Fig. 1 ist für verschiedene Drucke der Prozeßparameterbereich dargestellt, in dem ein stabiles Aufrechterhalten der Plasmen in der verwendeten Anlage möglich ist. In der Anlage befindet sich dabei eine unbehandelte Siliziumscheibe. Auf der X-Achse die 13,56 MHz RF-Leistung und auf der Y-Achse die 100 kHz RF-Leistung aufgetragen. Wertepaare entlang der Kurven entsprechen einem stabilen Aufrechterhalten von Plasmen. Die Kurve mit dem Bezugszeichen 11 gilt für einen Druck von 2,7 hPa, die Kurve mit dem Bezugszeichen 12 gilt für einen Druck von 6,7 hPa und die Kurve mit dem Bezugszeichen 13 gilt für einen Druck von 13,3 hPa. Aus Fig. 1 geht hervor, daß der verfügbare Prozeßparameterbereich für den niedrigsten Druck (Kurve 11) am größten ist. In diesem Fall ist die Dichte reaktiver Teilchen am größten.

Zur Ermittlung der optimalen Prozeßparameter werden blanke Halbleitersubstrate, z. B. aus Silizium, ohne jegliche Maskenschichten oder Phototechnik dem Niederdruckplasmaätzprozeß unterzogen. Die Prozeßparameter - Druck, 100 kHz RF-Leistung und 13,56 MHz RF-Leistung - wurden variiert. Die Prozesse wurden jeweils mit einer Dauer von 1 Minute durchgeführt. Da die Substratschädigung von der Prozeßdauer unabhängig ist, wie aus M. Engelhardt, Proc. 9th Int. Symp.1 on Plasma Chemistry (ISPC-9) Sept. 1989, p. 978 (1989) bekannt ist, ist diese Dauer für das Ergebnis unkritisch.

Die Substratschädigung wurde nach jedem Prozeß mit Hilfe des Thermal-Wave-Verfahrens gemessen. Dabei werden in der Substratoberfläche berührungslos z. B. mit einem Laser Temperatur- und Plasmawellen angeregt. Die Wechselwirkung zwischen Temperatur- und Plasmawellen und der Oberfläche des Halbleitersubstrats stellt ein Maß für die Substratschädigung des Halbleitersubstrats dar. Sie wird z. B. über die veränderte Reflektivität der Oberfläche des Halbleitersubstrats gemessen. Die Messungen erfolgten unter Verwendung des Systems Therma Probe 200 der Firma Therma Wave Inc..

In Fig. 2 ist das Ergebnis von Ätzprozessen dargestellt, bei denen bei vorgegebener 13,56 MHz RF-Leistung von 1000 W für verschiedene Drucke die Abhängigkeit der Substratschädigung von der 100 kHz RF-Leistung untersucht wurde. △ TW bedeutet die Zunahme der Substratschädigung durch den Ätzprozeß in beliebigen, im System Therma Probe 200 verwendeten Einheiten. Die Kurve 21 zeigt die Meßwerte für einen Druck von 2,7 hPa die Kurve 22 für 6,7 hPa und die Kurve 23 für 13,3 hPa. Es ergibt sich eine Abnahme der Substratschädigung △ TW mit abnehmenden Druck und abnehmender 100 kHz RF-Leistung. Das ist gleichbedeutend mit der Abnahme der kinetischen Energie der reaktiven Teilchen im Plasma.

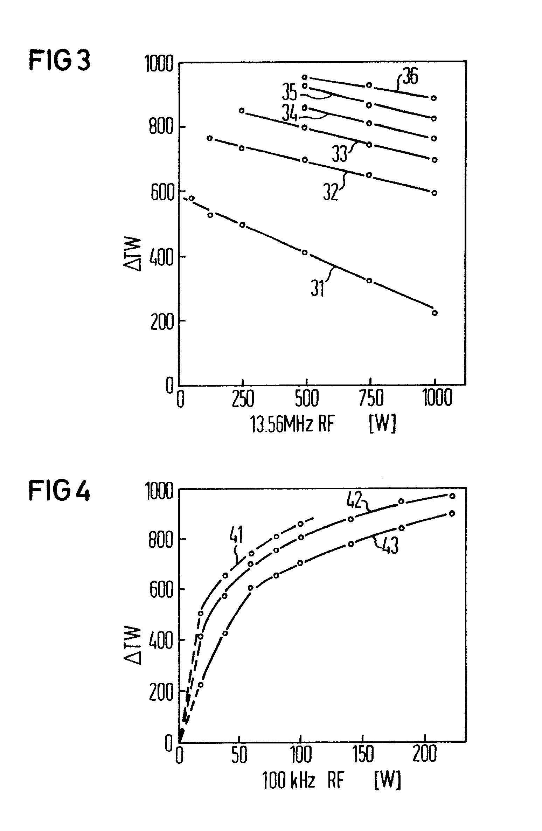

Fig. 3 zeigt das Ergebnis der Untersuchung der Abhängigkeit der Substratschädigung von der 13,56 MHz RF-Leistung für verschiedene 100 kHz RF-Leistungen bei einem festen Druck von 2,7 hPa. Die Kurve 31 zeigt die Ergebnisse für eine 100 kHz RF-Leistung von 20 Watt, die Kurve 32 von 60 Watt, die Kurve 33 von 100 Watt, die Kurve 34 von 140 Watt, die Kurve 35 von 180 Watt und die Kurve 36 von 220 Watt. Die Substratschädigung △ TW nimmt mit zunehmender 13,56 MHz RF-Leistung ab, was durch die Zunahme der Dichte reaktiver Teilchen erklärt wird. Die Zunahme der Dichte reaktiver Teilchen führt zu einer Verringerung der Peak-to-Peak-Spannung und so zu einer Verringerung der kinetischen Energie der reaktiven Teilchen im Plasma.

Fig. 4 zeigt die Abhängigkeit der Substratschädigung △ TW von der 100 kHz RF-Leistung, wobei die 13,56 MHz RF-Leistung als Parameter für die Kurvenschar gewählt ist. Die Kurve 41 entspricht einer 13,56 MHz RF-Leistung von 250 W, die Kurve 42 von 500 W und die Kurve 43 von 1000 W. Auch für diese Darstellung gilt der Druck von 2,7 hPa.

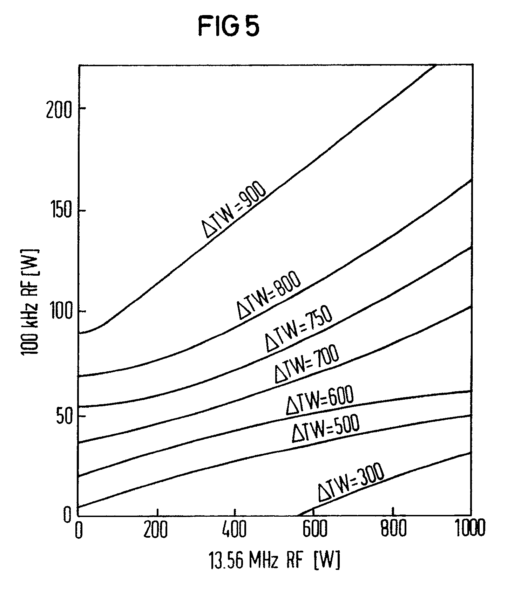

In Fig. 5 sind in der durch die 13,56 MHz RF-Leistung und die 100 kHz RF-Leistung aufgespannten Ebene Kurven gleicher Substratschädigung dargestellt. Die Kurven sind mit den Werten für die Substratschädigung △ TW bezeichnet. Aus Fig. 5 ist das Gebiet der minimalen Substratschädigung zu entnehmen.

Das erfindungsgemäße Verfahren für hinsichtlich minimaler Substratschädigung optimalen Parametern für einen Trockenätzprozeß hat gegenüber bekannten Verfahren den enormen Vorteil, daß der Prozeßparameterbereich mit unbehandelten Halbleiterscheiben ermittelt wird. Auf diese Weise wird vermieden, daß an den Halbleiterscheiben Prozeßschritte wie z. B. Phototechnik, Maskentechnik, Siliziumoxidabscheidung, durchgeführt werden, ehe der optimale Prozeßparameterbereich feststeht.

**Patentansprüche**

1. Verfahren zur Ermittlung eines Zusammenhangs zwischen einer Substratschädigung und Prozeßparametern für einen Trockenätzprozeß mit folgenden Schritten:

a) mindestens eine unbehandelte Halbleiterscheibe wird dem Trockenätzprozeß unterzogen, wobei die Prozeßparameter für stabile Prozeßbedingungen eingestellt werden,
b) in der Oberfläche der Halbleiterscheibe werden berührungslos Temperatur- und Plasmawellen angeregt,
c) die Stärke der Wechselwirkung der Temperatur- und Plasmawellen mit der Oberfläche der Halbleiterscheibe wird berührungslos gemessen.

2. Verfahren nach Anspruch 1,
**dadurch gekennzeichnet,** daß die Temperatur- und Plasmawellen mit Hilfe eines Lasers angeregt werden.

3. Verfahren nach Anspruch 2,
**dadurch gekennzeichnet,** daß die Wechselwirkung zwischen den Temperatur- und Plasmawellen und der Oberfläche der Halbleiterscheibe über die veränderte Reflektivität der Oberfläche der Halbleiterscheibe gemessen wird.

4. Verfahren nach einem der Ansprüche 1 bis 3,
**dadurch gekennzeichnet,** daß der Trockenätzprozeß in einem Niederdruckplasma in einem Druckbereich unter 10 hPa durchgeführt wird.

FIG 1

FIG 2

FIG 3

FIG 4

# FIG 5